## Europäisches Patentamt

(19) **European Patent Office**

**Office européen des brevets**

(11) Publication number: **0 202 038 B1**

(12) **EUROPEAN PATENT SPECIFICATION**

(45) Date of publication of the patent specification: **16.08.89**

(51) Int. Cl.⁴: **H 01 L 29/52, H 01 L 29/60, H 01 L 29/72**

(21) Application number: **86303006.0**

(22) Date of filing: **21.04.86**

(54) **Bipolar transistor.**

(30) Priority: **26.04.85 GB 8510725**

(43) Date of publication of application:
**20.11.86 Bulletin 86/47**

(45) Publication of the grant of the patent:
**16.08.89 Bulletin 89/33**

(84) Designated Contracting States:
**AT BE CH DE FR GB IT LI LU NL SE**

(56) References cited:
**US-A- 4 225 874**
**US-A- 4 253 105**
**US-A- 4 291 324**

(73) Proprietor: **BRITISH TELECOMMUNICATIONS public limited company, 81 Newgate Street, London EC1A 7AJ (GB)**

(72) Inventor: **Holmes, Phillip Edward, 15 Ramsgate Drive, Ipswich Suffolk (GB)**
Inventor: **Welbourn, Anthony David, 7 Fishbourne Close, Ipswich Suffolk (GB)**
Inventor: **Chandler, Timothy John, 8 Longcroft Road, Colchester Essex (GB)**

(74) Representative: **Purell, Kevin John et al, British Telecom Intellectual Property Unit 13th Floor 151 Gower Street, London WC1E 6BA (GB)**

## Description

This invention relates to a bipolar transistor suitable for high speed operation and which comprises semiconductor regions of a first conductivity type each having a contact and forming collector and emitter regions and an intermediate semiconductor region of a second conductivity type forming a base region having two contacts each connected to opposed sides of the base region.

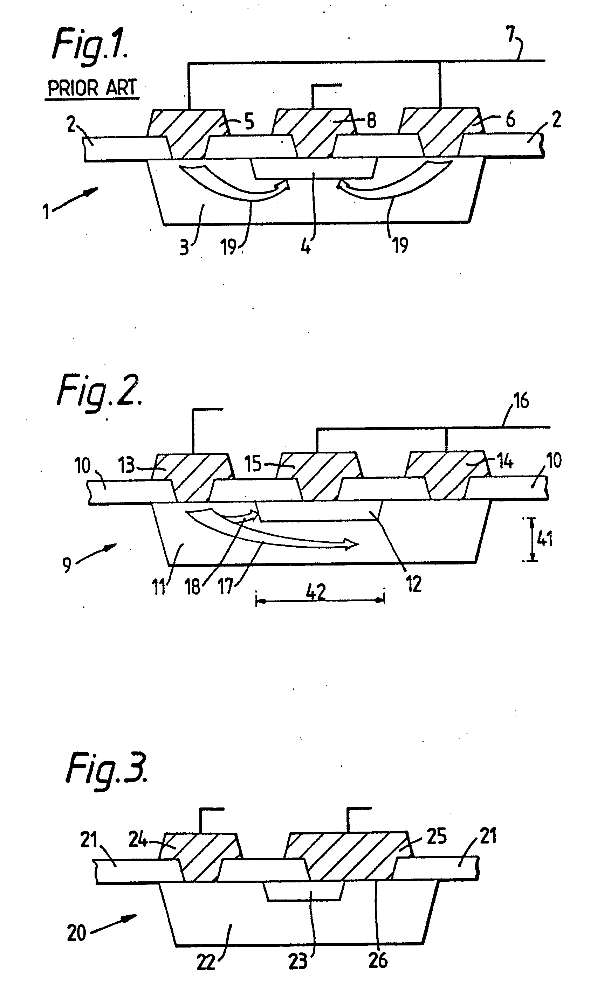

Bipolar transistors of this type are known in the art for example that disclosed in «A Junction Transistor Tetrode for high frequency use» Proc. IRE 40 (1952) pp 1395-1400. This discloses an n-p-n transistor having a base contact on each of two opposed edges of the base region. Currently bipolar transistors are mainly used for high speed memory and logic devices. «High speed» in this context means capable of sub nanosecond switching times; that is, operable at clock rates in excess of 1 GHz. A major factor inhibiting the speed of operation of such devices is the base-spreading resistance of the transistor. It is known to limit the effect of this to a certain extent by shorting contacts connected to each of two opposed edges of the base region to form a single base connection. Such an arrangement is shown in Figure 1. In Figure 1 a bipolar transistor is shown in cross section in which a collector semiconductor region 1 covered by a silicon dioxide layer 2, surrounds a base region 3 which surrounds an emitter region 4. Metal contact layers (5, 6) are provided for the base regions on either side of the emitter region and are connected together to form a common base connection 7. A separate metal contact layer 8 is also provided for the emitter region 4.

However such an arrangement still has a considerable base resistance which limits the speed of operation of such transistors. This is made worse when the width of the base region is decreased in order to try to achieve shorter transit times and higher speeds of operation since the sheet resistivity of the base region increases as the base width decreases. Thus whilst a high value of $f_T$ (the frequency at unity common emitter current gain) may be obtained with such an arrangement the improvement in the value of fmax (the frequency at unity power gain) is much less significant.

The connection of a central part of the base region to the emitter contact is also known in the context of bipolar power transistors from US patent number 4 225 874 and 4 291 324. However in US 4 225 874 the reason for providing the connection is to provide a diode which acts to prevent damage to the base-collector p-n junction when it is reverse biased with a high voltage. In US 4 291 324 a high resistance pillar extends from the base region through the annular emitter region to contact the centre of the emitter contact to provide a shunt ballasting structure which gives protection against forward and reverse second breakdown.

According to the present invention there is provided a bipolar transistor suitable for high speed operation, comprising semiconductor regions of a first conductivity type each having a contact and forming collector and emitter regions and an intermediate semiconductor region of a second conductivity type forming a base region having two contacts each connected to opposed sides of the base region wherein one of the contacts connected to an edge of said base region is connected to the contact connected to said emitter region, thereby effectively shorting said emitter region to one edge of said base region so that on operation a current flowing laterally in said base region beneath said emitter region debiasses all but a portion of said emitter region adjacent to said other base contact.

Preferably the transistor is a planar transistor formed by diffusion or deposition of said semiconductor regions and contacts in or into a substrate.

More preferably the contact for the emitter and that connected to one edge of the base region to which the emitter contact is connected are integral.

The transistor is preferably of n-p-n construction though p-n-p construction may be used.

The transistor according to the present invention by effectively shorting the emitter to one edge of the base region enables the creation of a lateral current flow beneath the emitter which causes a voltage drop across the width of the emitter. This enables only the edge of the emitter closest to the base contact itself to be biassed on so that all the base current enters the emitter there. The route travelled by the base current is thus considerably shorter and the base resistance consequently less than for prior art arrangements. The current flowing laterally in the base region thus de-biases most of the base-emitter junction giving an effective submicron emitter stripewidth. This reduces the need for reducing the emitter width to submicron levels (which would be necessary in conventional devices with base widths of less than about 0.2 μm) which would involve difficulties with the lithography required. The lateral electric field thus created in the base region gives rise to the name of devices according to the present invention - Base Field Transistor (BFT).

The creation of such a field in a BFT would be expected to give the device an undesirably low forward current gain due to the bias current flowing from the base contact beneath the emitter. However, in the BFT whilst the intrinsic base resistance can remain small due to both the small effective emitter width and the high degree of current crowding the high resistivity of the intrinsic base region acts as an advantage instead of a disadvantage since it reduces the de-biassing current flowing beneath the emitter thus improving the forward current gain.

A further advantage of the BFT arises in integration of such devices as significant savings in overall device area may be made. The overall dimensions are dictated by metal pitches and alignment tolerances and in the BFT some of these tolerances may be eliminated resulting in a smaller total device area. Such a reduction in overall area also brings the advantage that the collector substrate and collector base capacitances are reduced.

Embodiments of devices according to the present invention will now be described in more detail with reference to the accompanying drawings in which:

Figure 1 shows a diagrammatic cross section of a bipolar transistor according to the prior art having common base connections.

Figure 2 shows a diagrammatic cross section of a bipolar transistor according to a first embodiment of the first embodiment of the present invention .

Figure 3 shows a diagrammatic cross section of a bipolar transistor according to a further embodiment of the present invention.

In Figure 2 a cross section of a bipolar transistor according to an embodiment of the present invention is shown having a planar construction. A collector region 9 is covered by a silicon dioxide layer 10 and surrounds a base region 11 (of width 41) which surrounds an emitter region 12. Metal contact layers (13, 14) are provided for the base regions on either side of the emitter region (of width 42). A metal contact 15 is provided for the emitter region 12. The emitter region contact 15 and one of the opposed base contacts 14 are connected together to form an emitter contact 16. The connection of these two contacts results in the flow of a debiasing current 17 beneath the emitter region and between the two base contacts. This current is rendered small by the high resistivity of the intrinsic base region and thus the forward current gain of the transistor need not be adversely affected. Commonly a forward current gain of about a factor of 40 is required for bipolar transistors used in digital circuits and such a gain figure can still be obtained using transistors according to the present invention. The effect of the debiasing current though is to debias all but a portion of the emitter region 12 adjacent the base contact 13. It is thus only at this point that the base current 18 flows to the emitter. The route taken by the base current 18 is thus considerably shorter than that taken by the base current 19 in transistors according to the prior art as shown in Figure 1. This short base current route, effectively very thin emitter width and high degree of current crowding all result in a considerably lower intrinsic base resistance and thus higher operating speed. This is achieved despite the high resistivity of the intrinsic base region which in fact serves as an advantage in reducing the debiasing current and thus preserving a useful forward current gain.

Transistors according to the present invention preferably have base widths of less than 0.5 μm, and more preferably of less than 0.2 μm. Beause of the effective reduction in emitter width with transistors according to the present invention, it is no longer the actual printed size of the emitter which determines the minimum acceptable base width. It is therefore possible, for a given emitter width, to use a smaller base width than is feasible with conventional constructions. Hence, even with «easily» printed 1 to 2 μm printed emitter widths, it is possible to have base widths of less than 0.2 μm.

Furthermore the achievement of these effects by connecting the emitter contact to one of the base contacts enables the device to be fabricated using any existing bipolar process or construction without any additional processing steps. The device though is particularly suitable for fabrication processes involving a polysilicon coated emitter process. Whilst the presence of the debiasing current reduces the forward current gain this reduction is not as great as might be expected due to the high resistivity of the intrinsic base region. The use of a polysilicon emitter electrode is advantageous in that it increases the gain of what is inherently a low gain device. A thin interfacial layer is formed between the polysilicon and the material of the base. Because electrons tunnel through this interfacial layer better than do holes, injection of electrons from the emitter to the base is more efficient than is injection of holes from base to emitter. Hence the device still gives a useful gain and also has greatly enhanced emitter efficiency.

The connection of the emitter contact to one of the base contacts also enables substantial advantages in the reduction of the device area to be achieved. One particular way of increasing such savings is to amalgamate the emitter contact and the base contact to which it is connected thus using a single integral emiter contact which also contacts one side of the base region. Such an arrangement is shown in Figure 3 where a collector region 20 is covered by a silicon dioxide layer 21 and surrounds a base region 22 which surrounds an emitter region 23. The base region is provided with a contact 25 which contacts not only the emitter region 23 but also one side of the base region 26 on the opposite side of the emitter to that on which the side of the base region carrying the base contact 24 is located. The integral contact thus overlies the exposed emitter base junction. Using this manner of construction the overall area occupied by the device is considerably reduced. By such reductions in the metal pitches and alignment tolerances required, the device can be reduced in size without any adverse affects. In fact considerable advantages arise since the reduction in device area results in a reduction in the collector substrate and collector base capacitances of the device with consequently improved performance. The increased speed of operation, reduction in size and capacitance renders devices according to the present invention particularly suited to use in high speed digital integrated cicuit applications.

## Claims

1. A bipolar transistor suitable for high speed operation, comprising semiconductor regions of a first conductivity type each having a contact and forming collector (9; 20) and emitter (12; 23) regions and an intermediate semiconductor region of a second conductivity type forming a base region (11; 22) having two contacts (13, 14; 24, 25) each connected to opposed sides of the base region wherein one (14; 25) of the contacts connected to an edge of said base region is connected to the contact (15; 25) connected to said emitter region, thereby effectively shorting said emitter region to one edge of said base region so that on operation a current flowing laterally in said base region beneath said emitter region debiasses all but a portion of said emitter region adjacent to said other base contact (13; 24).

2. A transistor according to claim 1 wherein the transistor is of planar construction.

3. A transistor according to claim 1 or 2 wherein the emitter contact and the base contact to which it is connected are integral.

4. A transistor according to claim 3 wherein said integral contact overlies the junction between said emitter and said side of the base region to which said integral contact is connected where said junction is exposed at a surface of the device.

5. A transistor according to any one of the preceding claims wherein said first conductivity type of semiconductor is n-type and said second conductivity type of semiconductor is p-type.

6. A transistor as claimed in any one of claims 2 to 5 wherein said emitter region is provided with a polysilicon emitter electrode.

7. An integrated circuit comprising a plurality of transistors as claimed in any one of claims 1 to 6 integrated on a common substrate.

## Patentansprüche

1. Bipolartransistor für Hochgeschwindigkeitsbetrieb, mit Halbleitergebieten eines ersten Leitfähigkeitstyps, von denen jedes einen Kontakt besitzt und Kollektor (9; 20) und Emittergebiete (12; 23) bildet, und mit einem Halbleiterzwischengebiet eines zweiten Leitfähigkeitstyps, das ein Basisgebiet (11; 22) mit zwei Kontakten (13, 14; 24, 25) bildet, welche an entgegengesetzten Seiten des Basisgebietes angeschlossen sind, wobei einer (14; 25) der an einen Rand des Basisgebietes angeschlossenen Kontakte mit dem an das Emittergebiet angeschlossenen Kontakt (15; 25) verbunden ist, wodurch das Emittergebiet mit dem einen Rand des Basisgebietes effektiv kurzgeschlossen wird, so daß im Betrieb ein Strom, der seitlich im Basisgebiet unterhalb des Emittergebietes fließt, das ganze Emittergebiet bis auf einen, an den anderen Basiskontakt (13; 24) angrenzenden, Abschnitt vorspannungsfrei macht.

2. Transistor nach Anspruch 1, wobei der Transistor Planarstruktur aufweist.

3. Transistor nach Anspruch 1 oder 2, wobei der Emitterkontakt und der Basiskontakt, an den er angeschlossen ist, ein einziges Stück bilden.

4. Transistor nach Anspruch 3, bei der der einstückige Kontakt den Übergang zwischen dem Emitter und jener Seite des Basisgebietes, mit der der einstückige Kontakt verbunden ist, an der Stelle bedeckt, wo sich der Übergang an der Oberfläche des Schaltungselementes exponiert.

5. Transistor nach einem der vorhergehenden Ansprüche, bei dem der erste Leitfähigkeitstyp ein Halbleiter vom n-Typ und der zweite Leitfähigkeitstyp ein Halbleiter vom p-Typ ist.

6. Transistor nach einem der Ansprüche 2 bis 5, bei dem das Emittergebiet mit einer Polysiliziumemitterelektrode versehen ist.

7. Integrierter Schaltkreis mit einer Vielzahl von Transistoren nach einem der Ansprüche 1 bis 6, wobei die Transistoren in ein gemeinsames Substrat integriert sind.

## Revendications

1. Un transistor bipolaire approprié pour un fonctionnement à grande vitesse, comprenant des zones semi-conductrices d'un premier type de conductivité comportant chacune un contact et formant des zones de collecteur (9; 20) et d'émetteur (12; 23) ainsi qu'une zone semi-conductrice intermédiaire d'un second type de conductivité formant une zone de base (11; 22) comportant deux contacts (13, 14; 24, 25) qui sont chacun reliés à des côtés opposés de la zone de base, transistor dans lequel un (14; 25) des contacts reliés avec un bord de ladite zone de base est connecté au contact (15; 25) qui est relié à ladite zone d'émetteur, en court-circuitant ainsi efficacement ladite zone d'émetteur avec un bord de ladite zone de base de telle sorte que, en fonctionnement, un courant s'écoulant latéralement dans ladite zone de base en dessous de ladite zone d'émetteur dépolarise la totalité de ladite zone d'émetteur sauf une partie qui est adjacente audit autre contact de base (13; 24).

2. Un transistor selon la revendication 1, dans lequel le transistor est d'une structure planaire.

3. Un transistor selon une des revendications 1 ou 2, dans lequel le contact d'émetteur et le contact de base auquel il est relié sont unitaires.

4. Un transistor selon la revendication 3, dans lequel le contact unitaire est placé au-dessus de la jonction entre ledit émetteur et ledit côté de la zone de base auquel ledit contact unitaire est relié et où ladite jonction est exposée sur une surface du dispositif.

5. Un transistor selon une quelconque des revendications précédentes, dans lequel ledit premier type de conductivité du semi-conducteur est du type-n et ledit second type de conductivité du semi-conducteur est de type-p.

6. Un transistor tel que revendiqué dans une quelconque des revendications 2 à 5, dans lequel ladite zone d'émetteur est pourvue d'une électrode d'émetteur en polysilicium.

7. Un circuit intégré comprenant une pluralité de transistors tels que revendiqués dans une quelconque des revendications 1 à 6 et intégrés sur un substrat commun.

# Fig.1.

PRIOR ART

# Fig.2.

# Fig.3.